# EUROPEAN PATENT APPLICATION

(11) **EP 4 002 411 A1**
(43) Date of publication of application: **25.05.2022**
(21) Application number: 20844230.1
(22) Date of filing: 29.05.2020
(51) Int. Cl.: H01H 9/02, F16B 5/08, B23K 26/21, H01H 11/00, H01H 19/04, B29C 65/16, H05K 5/00

(54) **ELECTRONIC COMPONENT AND METHOD FOR MANUFACTURING SAME**

(30) Priority: 19.07.2019 JP 2019133926
(71) Applicant: Nidec Copal Electronics Corporation, Shinjuku-ku Tokyo 160-0023 (JP)
(72) Inventor: KOMURO, Tadashi, Sano-shi, Tochigi 327-0104 (JP); KITSU, Syoto, Sano-shi, Tochigi 327-0104 (JP)
(74) Representative: Zech, Stefan Markus
(86) International application number: PCT/JP2020/021468
(87) International publication number: WO 2021/014761

(57) **Abstract**

An electronic component 10 includes a housing 11 and a cover 12. The housing 11 includes a concave portion 11a accommodating therein elements. The cover 12 covers the concave portion. A laser-welded portion 17 including a discontinuous portion 19 is provided along a circumference of the concave portion of the housing and fixes the cover to the housing.

## Description

### Technical Field

Embodiments of the present invention relate to a surface-mount type electronic component to be mounted on, for example, a surface of a printed board only by soldering and manufacturing method of the same.

### Background Art

A surface-mount type electronic component (hereinafter referred to as a surface-mount component) is, in general, placed on a solder paste applied to the printed board and then the solder paste is subjected to reflowing, whereby the component is soldered to the printed board. Thereafter, the printed board is washed in order that the flux and the like can be removed. At this time, the surface-mount component has a sealed structure in order to prevent the cleaning liquid from entering the inside of the surface-mount component.

When the solder is subjected to reflowing, the surface-mount component is exposed to a high temperature, and hence the air inside the component is expanded. Accordingly, a surface-mount component including a valve for discharging the expanded air inside the component is developed (see, for example, Patent Literature 1).

### Citation List

### Patent Literature

Patent Literature 1: JP H04-129113 A

### Summary of Invention

In recent years, there are also many cases where even a washable surface-mount component is actually used without being washed. In this case, the surface-mount component requires no airtightness.

Accordingly, it is conceivable that two types of components, i.e., a washable component having an airtight structure and component having no airtight structure and requiring no washing are prepared in advance, and the two types of components are used according to the use application. However, when both the component having the airtight structure and component having no airtight structure are to be prepared, it is necessary to make the shapes of the two types of components different from each other, and thus the number of elements constituting the electronic component is increased and manufacturing cost is also increased.

Embodiments described herein aim to provide an electronic component making it possible to configure both airtight and non-airtight electronic components while preventing the number of elements constituting the electronic component from being increased and also preventing the manufacturing cost from being increased, and manufacturing method of the electronic component.

An embodiment of an electronic component comprises a housing including a concave portion in which elements are to be accommodated, a cover which covers the concave portion, and a laser-welded portion provided along a circumference of the concave portion of the housing, fixing the cover to the housing, and including a discontinuous portion.

An embodiment of a manufacturing method of an electronic component comprises providing, to a housing including a concave portion accommodating therein elements, a cover used to cover the concave portion; and applying laser light from the cover side to thereby form, along a circumference of the concave portion of the housing, a laser-welded portion fixing the cover to the housing and including a discontinuous portion.

### Brief Description of Drawings

FIG. 1 is a view showing an electronic component according to an embodiment and is a partially-exploded perspective view showing the state thereof before laser welding.
FIG. 2 is a view showing the electronic component according to this embodiment and is a perspective view showing the state thereof after laser welding.
FIG. 3 is a cross-sectional view along line III-III of FIG. 1.
FIG. 4 is a cross-sectional view along line IV-IV of FIG. 2.
FIG. 5 is a cross-sectional view showing an example of a laser welding device to be applied to the manufacture of the electronic component according to this embodiment.
FIG. 6 is a view showing the electronic component according to this embodiment and is a perspective view showing another state thereof after laser welding.
FIG. 7A is a view showing the electronic component according to this embodiment and is a plan view showing the state thereof after laser welding.
FIG. 7B is a view showing the electronic component according to this embodiment and is a plan view showing another state thereof after laser welding.
FIG. 7C is a view showing an electronic component according to a first modified example of this embodiment and is a plan view showing the state thereof after laser welding.
FIG. 7D is a view showing an electronic component according to a second modified example of this embodiment and is a plan view showing the state thereof after laser welding.

### Mode for Carrying Out the Invention

An embodiment of the present invention will be described below with reference to the accompanying drawings. In the drawings, identical parts are denoted by identical reference symbols.

### (Embodiment)

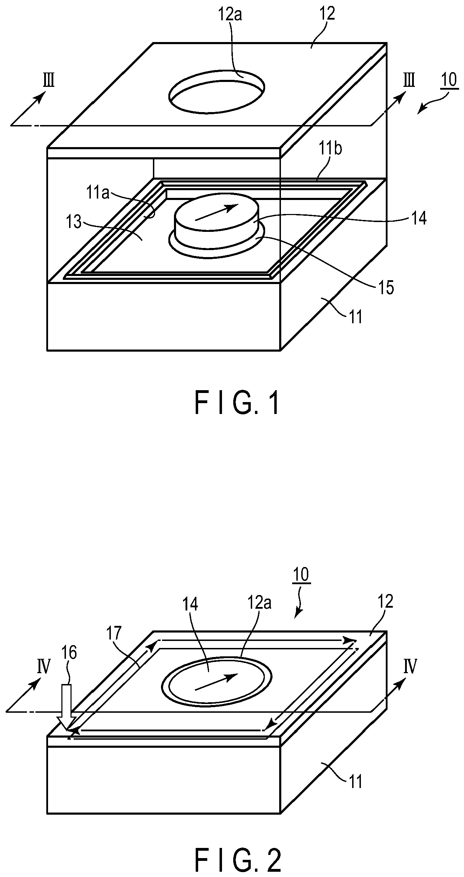

FIGS. 1 to 4 each show an electronic component 10 according to an embodiment. The electronic component 10 is a surface-mount component and, FIGS. 1 to 4 each show the electronic component 10 of a case where the component 10 is a dual in-line package (DIP) switch, e.g., a rotary switch. However, this embodiment is not limited to the switch, and can be applied to other electronic components.

The electronic component 10 includes, for example, a housing 11 functioning as a case, cover 12, switch mechanism 13, operator 14, and O-ring 15. The housing 11 is formed of a fusible resin configured to absorb, for example, laser light as will be described later, and includes a concave portion 11a accommodating therein the switch mechanism 13. Furthermore, the housing 11 includes a protrusion 11b which is continuously provided around the concave portion 11a and absorbs and melts the laser light.

The protrusion 11b fixes the cover 12 to the housing 11 in the molten state. However, the protrusion 11b can also be omitted. That is, when it is possible to melt a part of the housing 11 around the concave portion 11a, sufficiently join the cover 12 to the housing 11, and maintain the airtightness inside the concave portion 11a, the protrusion 11b can be omitted.

The cover 12 is formed of a translucent resin, and an opening 12a is provided at a central part of the cover 12. The operator 14 is inserted in the opening 12a in a rotatable manner. The operator 14 is coupled to the switch mechanism 13, and is operated to turn on/off the switch mechanism 13.

The part between the operator 14 and cover 12 is made an airtight structure, and moisture and dust are thereby prevented from entering the inside of the housing 11. More specifically, between the circumference of the operator 14 and cover 12, for example, an O-ring formed of rubber is provided.

The configuration of the switch mechanism 13 is not the essentiality of this embodiment, and hence the specific configuration thereof is not shown. However, it is possible for the switch mechanism 13 to include a plurality of fixed contacts (not shown), common contact, moving contact coupled to the operator 14 and configured to electrically connect the fixed contact and common contact to each other, and the like.

### (Manufacturing Method)

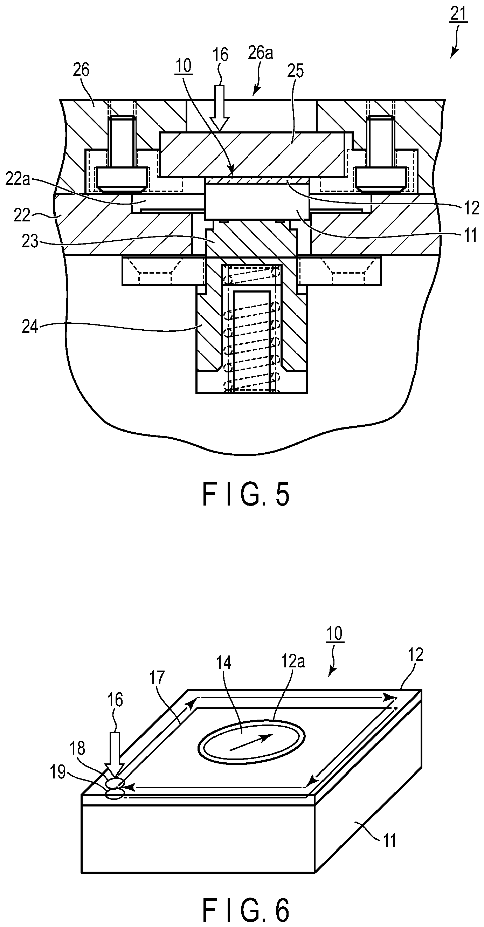

FIG. 5 shows an example of a laser welding device 21 to be applied to the manufacture of the electronic component according to this embodiment.

The laser welding device 21 includes a base table 22, first jig 23, pressing member 24, transparent plate 25, second jig 26, and the like. The base table 22 made of, for example, a metal includes an opening 22a, and first jig 23 made of a metal is arranged inside the opening 22a. The first jig 23 is placed on the pressing member 24.

The electronic component 10 is placed on the first jig 23. The transparent plate 25 made of, for example, glass is placed on the electronic component 10, and transparent plate 25 is held by the second jig 26 made of a metal. The second jig 26 includes an opening 26a having an area greater than the area of the top surface of the electronic component 10, and inner circumference of the opening 26a of the second jig 26 is kept in contact with the transparent plate 25. In this state, the first jig 23 is pressed toward the transparent plate 25 side by the pressing member 24, whereby the electronic component interposed between the first jig 23 and transparent plate 25 is held by the jig 23 and plate 25.

As shown in FIG. 1, at the time of manufacture of the electronic component 10, first, the switch mechanism 13 and operator 14 are incorporated into the concave portion 11a of the housing 11. Subsequently, as shown in FIG. 2, the cover 12 is placed on the protrusion 11b, and concave portion 11a of the housing 11 is covered with the cover 12.

In the state where the cover 12 is placed on the housing 11 as described above, the electronic component 10 is set between the first jig 23 of the laser welding device 21 and transparent plate 25 as shown in FIG. 5. Accordingly, the cover 12 is pressed against the housing 11.

In this state, the electronic component 10 is irradiated with laser light 16 from the opening 26a of the second jig 26 through the transparent plate 25. The irradiation position of the laser light 16 is correspondent to the protrusion 11b provided around the housing 11 and, the laser light 16 is moved along the protrusion 11b.

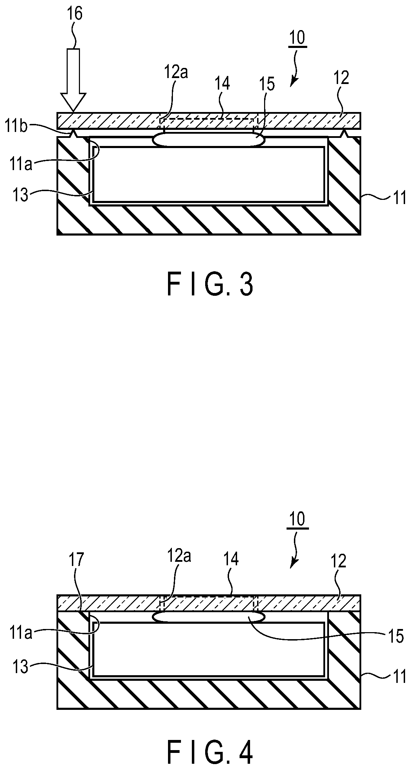

More specifically, as shown in FIGS. 2 and 3, the protrusion 11b is irradiated with the laser light 16 from the cover 12 side. The cover 12 of the electronic component 10 is formed of a translucent resin, and housing 11 is formed of a light-absorbing resin. Accordingly, the protrusion 11b is irradiated with the laser light 16 passing through the cover 12, and protrusion 11b absorbs the laser light 16 to thereby be melted. Accordingly, the cover 12 is welded to the housing 11 by the molten protrusion 11b.

When a washable electronic component 10 having an airtight structure is to be manufactured, the laser light 16 is moved along the protrusion 11b throughout the entire circumference of the concave portion 11a as shown in FIG. 2 by dotted line arrows. That is, the laser light 16 is continuously applied to the part around the concave portion 11a throughout the entire circumference thereof and, the irradiation starting position and irradiation ending position are made coincident with each other.

Accordingly, as shown in FIG. 2, along the entire circumference of the concave portion 11a of the housing 11, a welded portion 17 is continuously formed, and the entire circumference of the cover 12 is welded to the entire circumference of the housing 11 by the welded portion 17. Accordingly, as shown in FIG. 4, the concave portion 11a of the housing 11 is sealed up by the cover 12, and thus the washable electronic component 10 having the airtight structure is completed.

On the other hand, when an electronic component 10 having no airtight structure and requiring no washing is to be manufactured, the irradiation pattern of the laser light 16 is changed.

More specifically, as shown in FIG. 6, the irradiation starting position of the laser light 16 and irradiation ending position thereof are separate from each other, and a portion (unirradiated portion) 18 irradiated with no laser light 16 exists between the irradiation starting position and irradiation ending position. That is, the welded portion 17 configured to fix the cover 12 to the housing 11 is discontinuously formed along the circumference of the concave portion 11a. Accordingly, an unwelded portion 19 that is a discontinuous portion at which the cover 12 is not welded to the housing 11 is formed. Thereby, the greater part of the circumference of the cover 12 is fixed to the housing 11, and a small gap is formed between the housing 11 and cover 12 at the unwelded portion 19. More specifically, a gap is formed between the protrusion 11b which is not melted and is crushed very slightly by the pressure and cover 12. Accordingly, the electronic component 10 having no airtight structure and requiring no washing is completed. The gap between the protrusion 11b and cover 12 is very small. Accordingly, it is possible to prevent dust from entering the inside of the concave portion 11a from the gap.

It should be noted that it is not necessary to manufacture in advance two types of products, i.e., both an electronic component which has an airtight structure and is washable, and electronic component having no airtight structure and requiring no washing. For example, first, only electronic components 10 each including an unwelded portion 19 are manufactured in advance and, when it becomes necessary to manufacture a washable electronic component, the unwelded portion 19 is irradiated with the laser light so that a welded portion 17 can be formed, whereby it is possible to manufacture an electronic component which has an airtight structure and is washable.

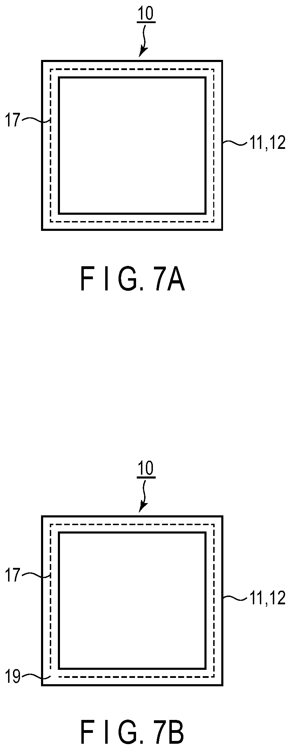

FIG. 7A shows the electronic component 10 which has the airtight structure and is washable and, the entire circumference of the concave portion 11a is completely surrounded with the welded portion 17 configured to join the housing 11 and cover 12 to each other.

FIG. 7B shows the electronic component 10 having no airtight structure and requiring no washing, the welded portion 17 is formed at the greater part of the circumference of the concave portion 11a, and unwelded portion 19 is formed at a part of the circumference thereof.

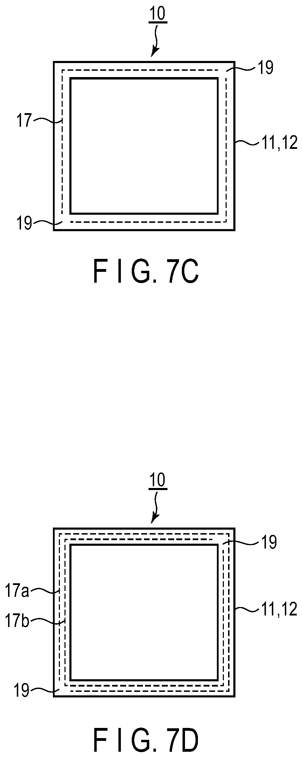

FIG. 7C shows a first modified example of a component having no airtight structure. The unwelded portion 19 is not limited to one position and unwelded portions 19 may also be formed at a plurality of positions. In the case of the first modified example shown in FIG. 7C, two unwelded portions 19 are formed at diagonal positions of a quadrilateral housing 11. The position of the unwelded portions 19 is not limited to the corner and may also be a part of the four sides. When a plurality of unwelded portions 19 are formed as described above, it is sufficient if the irradiation of the laser light 16 is stopped at positions corresponding to the unwelded portions 19.

In the embodiment described above, irradiation of the laser light 16 is carried out once around the concave portion 11a. However, the irradiation is not limited to this, and irradiation of the laser light 16 may also be carried out a plurality of number of times within the range of the width of the housing 11 around the concave portion 11a.

FIG. 7D shows a second modified example of the component having no airtight structure. In the case of the second modified example shown in FIG. 7D, irradiation of the laser light 16 is carried out, for example, doubly around the concave portion 11a. Accordingly, a first welded portion 17a on the outer side and second welded portion 17b on the inner side are formed.

Each of the first welded portion 17a on the outer side and second welded portion 17b on the inner side includes one unwelded portion 19. The unwelded portion 19 of the first welded portion 17a is arranged at one corner of the quadrilateral housing 11, and unwelded portion 19 of the second welded portion 17b is arranged at another corner of the quadrilateral housing 11. The number and positions of the unwelded portions 19 are not limited to the above.

In the case of this configuration, it is possible, at the time of the reflow, to discharge the expanded air inside the concave portion 11a to the outside of the housing 11 through the unwelded portion 19 of the second welded portion 17b and unwelded portion 19 of the first welded portion 17a. Moreover, the unwelded portion 19 of the second welded portion 17b is formed at a position separate from the unwelded portion 19 of the first welded portion 17a, and hence it is possible to prevent dust from entering the inside of the concave portion 11a, whereby the dust-entry preventing performance of this case is higher than the cases shown in FIGS. 7B and 7C.

### (Advantageous Effects of Embodiment)

According to this embodiment, the housing 11 and cover 12 are welded to each other by using laser light 16 and, by changing the irradiation pattern of the laser light 16, it is possible to manufacture both an electronic component which has airtightness and is washable and electronic component having no airtightness and requiring no washing. Owing to this, it is possible to manufacture both a washable electronic component and electronic component requiring no washing by using common components. Accordingly, it is possible to manufacture products having functions different from each other while preventing the number of elements from being increased, and prevent the manufacturing cost from being increased.

In general, when both a washable electronic component and electronic component requiring no washing are to be manufactured by, for example, ultrasonic welding, it is necessary to partially change the structure of the electronic component or partially change the device configured to apply ultrasonic vibration.

When, for example, the structure of the electronic component is to be changed, it is necessary, with respect to the washable electronic component, to provide a protrusion around the concave portion of the housing throughout the entire circumference thereof and, with respect to the electronic component requiring no washing, to provide a protrusion except for a part or parts of the circumference of the concave portion.

Further, when the structure of the device configured to apply ultrasonic vibration is to be changed, it is necessary, with respect to the washable electronic component, to prepare a component or components configured to apply the ultrasonic vibration to the entire circumference of the concave portion of the housing and, with respect to the electronic component requiring no washing, to prepare a component or components configured to apply the ultrasonic vibration to the circumference of the concave portion except for a part or parts of the circumference thereof.

Accordingly, when the structure of the electronic component is to be changed, the number of elements of the electronic component is increased and, when the structure of the device configured to apply the ultrasonic vibration is to be changed, the number of components of the manufacturing device is increased. Accordingly, in either case, the manufacturing cost of the products is increased.

Conversely, in the case of this embodiment, it is possible to manufacture the products having functions different from each other by only changing the irradiation pattern of the laser light 16, and hence it is possible to prevent the number of elements of the electronic component or number of components of the manufacturing device from being increased, and prevent the manufacturing cost from being increased.

Further, according to this embodiment, only the electronic components 10 each including an unwelded portion 19 or unwelded portions 19 and requiring no washing are manufactured in advance and, when the washable electronic component is required, the unwelded portion 19 or unwelded portions is or are irradiated with laser light 16, whereby it is possible to manufacture the washable electronic component having the airtight structure. In this case, it is not necessary to prepare both the types of the washable electronic components and electronic components requiring no washing as a stock. Accordingly, it is possible to reduce the number of items in stock.

The present invention is not limited to the embodiments described above but the constituent elements of the invention can be modified in various manners without departing from the spirit and scope of the invention. Various aspects of the invention can also be extracted from any appropriate combination of a plurality of constituent elements disclosed in the embodiments. Some constituent elements may be deleted in all of the constituent elements disclosed in the embodiments. The constituent elements described in different embodiments may be combined arbitrarily.

## Claims

1. An electronic component **characterized by** comprising:
a housing including a concave portion in which elements are to be accommodated;
a cover which covers the concave portion; and
a laser-welded portion provided along a circumference of the concave portion of the housing, fixing the cover to the housing, and including a discontinuous portion.

2. The electronic component of claim 1, **characterized in that**
the discontinuous portion is an unwelded portion.

3. The electronic component of claim 2, **characterized in that**
the laser-welded portion includes a first laser-welded portion including a first unwelded portion, and a second laser-welded portion including a second unwelded portion, and the first unwelded portion and the second unwelded portion are arranged along the circumference of the concave portion at positions separate from each other.

4. A manufacturing method of an electronic component **characterized by** comprising:
providing, to a housing including a concave portion accommodating therein elements, a cover used to cover the concave portion; and
applying laser light from the cover side to thereby form, along a circumference of the concave portion of the housing, a laser-welded portion fixing the cover to the housing and including a discontinuous portion.

5. The manufacturing method of an electronic component of claim 4, **characterized in that**
the discontinuous portion is an unwelded portion.

6. The manufacturing method of an electronic component of claim 5, **characterized in that**
the unwelded portion is changed into a laser-welded portion by being irradiated with the laser light.

7. The manufacturing method of an electronic component of claim 5, **characterized in that**
the laser-welded portion includes a first laser-welded portion including a first unwelded portion, and a second laser-welded portion including a second unwelded portion, and the first unwelded portion and the second unwelded portion are arranged along the circumference of the concave portion at positions separate from each other.
